# EUROPÄISCHE PATENTSCHRIFT

(11) **EP 0 343 530 B1**
(45) Veröffentlichungstag und Bekanntmachung des Hinweises auf die Patenterteilung: **14.11.2001**
(21) Anmeldenummer: 89109054.0
(22) Anmeldetag: 19.05.1989
(51) Int. Cl.: H01L 21/00

(54) **Vakuumanlage**
Vacuum installation
Installation sous vide

(30) Priorität: 24.05.1988 CH 195188; 15.07.1988 CH 272288
(43) Veröffentlichungstag der Anmeldung: 29.11.1989
(73) Patentinhaber: Unaxis Balzers Aktiengesellschaft, 9496 Balzers (LI)
(72) Erfinder: Wagner, Rudolf, CH-9476 Fontnas (CH); Bader, Martin, Dr., FL-9496 Balzers (LI); Moll, Eberhard, Dr., FL-9488 Schellenberg (LI); Zanardo, Renzo, FL-9496 Balzers (LI); Van Agtmaal, J.G., NL-1213 CE Hilversum (NL)
(74) Vertreter: Troesch, Jacques J., Dr. sc. nat.

(56) Entgegenhaltungen:
- EP-A- 0 187 249
- EP-A- 0 264 945
- US-A- 4 664 062

## Beschreibung

Die vorliegende Erfindung betrifft eine Vakuumanlage zum Behandeln von Werkstücken nach dem Oberbegriff von Anspruch 1.

Aus der Zeitschrift Solid State Technology/Oktober 1987 (Seiten 55/56) oder aus der EP-A-264 945 ist eine solche Mehrkammeranlage für die Behandlung von Siliziumwafern bekannt, die in einer zentralen Verteilerkammer einen Robotarm aufweist, der die einzelnen zu behandelnden Halbleiterscheiben gemäss einem vorgegebenen Programm den einzelnen Prozesskammern zuführt bzw. sie nach Durchführung eines Prozesses, z.B. einer Beschichtung, wieder daraus entnimmt. An eine solche zentrale Verteilerkammer kann eine Mehrzahl von Prozesskammern angeschlossen sein, wobei die Halbleiterscheiben, ohne dass sie zwischen den einzelnen Prozessen in die freie Atmosphäre übergeführt werden müssen, durch die Verteilerkammer hindurch von einer Prozesskammer in die andere befördert werden können. Bei sehr empfindlichen Prozessen besteht dabei aber die Gefahr, dass Restgase, die z.B. in einem Verfahrensschritt in einer Prozesskammer benötigt werden, in eine andere gelangen, wo sie den dort durchzuführenden Prozess stören, oder dass Partikel, die bei dem einen oder anderen Prozessschritt etwa aufgewirbelt werden, verschleppt werden. Auch können mit den noch unbehandelten Halbleiterscheiben aus dem Aussenraum in die Verteilerkammer eingebrachte Partikel beim Vorbeibewegen an teilweise bereits behandelten Halbleiterscheiben auf diese gelangen und die an diesen noch unbehandelten Halbleiterscheiben nachfolgend durchzuführenden Prozesse beeinträchtigen.

Es ist schon vorgeschlagen worden, die einzelnen Prozessschritte durch Druckstufenschleusen, die den Prozesskammern vorgeschaltet werden, z.B. mittels eines sogenannten Druckstufensystems, das aus drei separat auspumpbaren Vakuumkammern besteht und wobei die Wafer durch entsprechende Schlitze in den Wänden zwischen den einzelnen Kammern hindurch in die Prozesskammern befördert werden, zu entkoppeln. Hauptzweck der Druckstufenschleusen war dabei aber lediglich die Aufrechterhaltung einer Druckdifferenz zwischen den verschiedenen Räumen des Vakuumsystems.

Aus der US-A-4 664 062 ist eine Vakuumanlage für die Halbleiter-Fertigung mittels Molekularstrahl-Epitaxie (MBE) bekannt. An einer Transportkammer mit einem Transportmechanismus, sind, über Verschlusselemente, eine Ausgabekammer und zwei Prozesskammern angeflanscht. In einem Ausführungsbeispiel und zur weiteren Verbesserung der Anlage-Produktivität, werden der Transportkammer Werkstücke über eine Speicher-Kammer mit eigenem Transportmechanismus zugeführt. Diese ist über Verschlusselemente einerseits mit der Transportkammer, andererseits mit einer Ladekammer verbunden.

Die vorliegende Erfindung setzt sich, ausgehend von einer Anlage letztgenannter Art, zur Aufgabe, eine Vakuumanlage vorzuschlagen, bei der flexibel und je nach erwünschter Behandlung eine entsprechende Anzahl von Prozesskammern vorgesehen werden kann und dabei die Verschleppung von Restgasen und Partikeln von der einen Prozesskammer zur andern dort auf ein Minimum reduziert oder überhaupt ausgeschlossen werden kann, wo dies erforderlich ist. Darüber hinaus soll ermöglicht werden, diese Verschleppung zwischen Gruppen von Prozesskammern zu reduzieren.

Zur Lösung dieser Aufgabe weist die Vakuumanlage eingangs genannter Art die Merkmale des Kennzeichens von Anspruch 1 auf. In bevorzugter Ausführungsform der Erfindung können an die Verteilerkammer mehrere zweite Kammern mit zugeordneten Prozesskammern angeschlossen sein und/oder es werden einer zweiter Kammer mehrere Prozesskammern zugeordnet. Im weiteren werden die zweiten Kammern "Zwischenkammern" genannt.

Ein Ausführungsbeispiel der Erfindung wird anhand der anliegenden Zeichnungen näher erläutert. Es zeigen:
Fig. 1 in schematischer Darstellung einen Vertikalschnitt durch die Vakuumanlage;
Fig. 2 schematisch in Draufsicht die Vakuumanlage mit drei Zwischenkammern und neun Prozesskammern;
Fig. 3 in schaubildlicher Darstellung das Prinzip der Uebergabe einer Scheibe vom ersten zum zweiten Transport-Mechanismus;
Fig. 4 einen Vertikalschnitt durch einen in einer Zwischenkammer angeordneten Hubtisch mit Haltevorrichtung für die Scheibe, in einer ersten Hubstellung;
Fig. 5 den Hubtisch gemäss Fig. 4, in einer Zwischenstellung;
Fig. 6 den Hubtisch gemäss Fig. 4, in der Endstellung bei Behandlung der Scheibe in der Prozesskammer, und
Fig. 7 eine Ansicht von oben auf zum Hubtisch gehörende Teile.

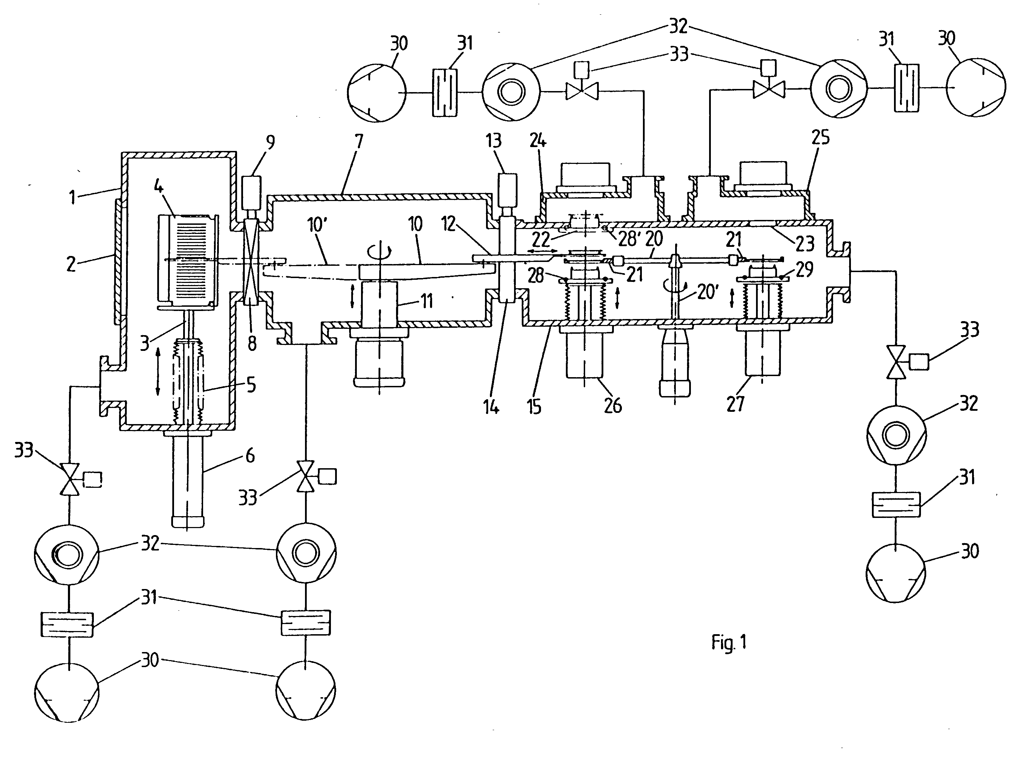

Figur 1 zeigt die Schleusenkammer 1 mit einem Tor 2 zur freien Atmosphäre und mit in der Kammer 1 angeordneter Halterung 3 für ein Wafermagazin 4. Dieses kann mittels einer mit Faltenbalgdichtung 5 und Betätigungsvorrichtung 6 versehenen Hubeinrichtung so gehoben und gesenkt werden, dass jeweils eine bestimmte zu behandelnde Scheibe des Magazins 4 in passender Höhe liegt für die Einführung in die Verteilerkammer 7 durch die Oeffnung des Ventils 8 hindurch; letzteres wird durch eine Betätigungseinrichtung 9 nach Bedarf geöffnet oder geschlossen.

In der Verteilerkammer 7 ist ein erster Mechanismus 10,11 zur Weiterbeförderung der jeweils dem Magazin entnommenen Scheibe an die Zwischenkammer 15 vorgesehen. Dieser Verteilermechanismus weist einen drehbar angeordneten Robotarm 10 auf, dem eine steuerbare Antriebsvorrichtung 11 zugeordnet ist. Der Robotarm 10 entnimmt beim Betrieb dem Magazin 4 mittels der Scheibenauflage 12 bei geöffnetem Ventil 8 jeweils eine Scheibe und bringt sie durch das geöffnete, durch die Hilfseinrichtung 13 betätigbare Ventil 14 in die Zwischenkammer 15. Bei Vorhandensein mehrerer Zwischenkammern wird die Scheibe in die dem Verfahrensprogramm jeweils entsprechende Zwischenkammer eingebracht.

In der Fig. 1 ist diejenige Stellung des drehbaren Robotarms 10, in welcher er die Scheibe vom Magazin 4 übernimmt, mit 10' strichpunktiert, dagegen die Stellung, in welcher er diese bei geöffnetem Ventil 14 an die Zwischenkammer 15 weitergibt, mit 10 in vollen Linien gezeichnet. In der Zwischenkammer 15, von welcher aus die Weitergabe der Scheiben an die einzelnen angeschlossenen Prozesskammern 24 und 25 erfolgt, in denen sie bestimmten Prozessschritten, z.B. einer Beschichtung oder einer Aetzung im Zuge eines Herstellungsverfahrens unterworfen werden, ist ein zweiter Mechanismus zur Handhabung der Scheiben untergebracht.

Dieser zweite Mechanismus ist ähnlich wie der erste als Dreharm 20 mit Greifern 21 für die Uebernahme der vom ersten Mechanismus überbrachten Scheiben ausgestaltet. Durch entsprechende Drehung der Greifer 21 längs einer Kreisbahn können die Scheiben unter die auf einem Kreis befindlichen Oeffnungen 22 und 23 zu den Prozesskammern 24 und 25 gebracht und von dort mittels Hubeinrichtungen 26 und 27 (die ähnlich wie diejenige in der Schleusenkammer 1 ausgestattet werden können) in die Behandlungspositionen der einzelnen Prozesskammern hochgehoben bzw. nach Durchführung einer Behandlung wieder abgesenkt und zu einer anderen Prozessstation weiterbefördert werden. Im gezeichneten Ausführungsbeispiel sind die Hubeinrichtungen noch mit Ringdichtungen 28 und 29 ausgestattet, die beim Anpassen derselben an die Decke der Zwischenkammern rund um die Oeffnungen 22 und 23 eine vakuumdichte Absperrung zwischen der Zwischenkammer und den Prozesskammern ergeben; in Fig. 1 ist die Schliessposition der Dichtung 28 mit 28' angedeutet.

Die Fig. 1 zeigt noch schematisch die den verschiedenen Kammern zugeordneten Pumpstände, von denen jeder z.B. aus einer Vorpumpe 30, einem Kondensator 31, einer Hochvakuumpumpe 32 und einem Ventil 33 bestehen kann. Sämtliche Ventile und die Pumpen können mit einem Steuermechanismus bzw. einem Steuercomputer verbunden werden, um sie einem gewünschten Prozessablauf entsprechend (welcher nicht den Gegenstand der vorliegenden Erfindung bildet) zu betätigen.

In Fig. 1 ist zwar nur eine vereinfachte Anordnung mit nur einer an die Kammer 7 angeschlossenen Zwischenkammer 15 dargestellt, doch ist es für den Fachmann ersichtlich, dass mit der Verteilerkammer 7 auch zwei oder mehrere Zwischenkammern verbunden werden könnten, von denen aus die Scheiben einem vorgegebenen Programm entsprechend durch den zweiten Mechanismus an die an die Zwischenkammern angeschlossenen Prozesskammern verteilt werden können.

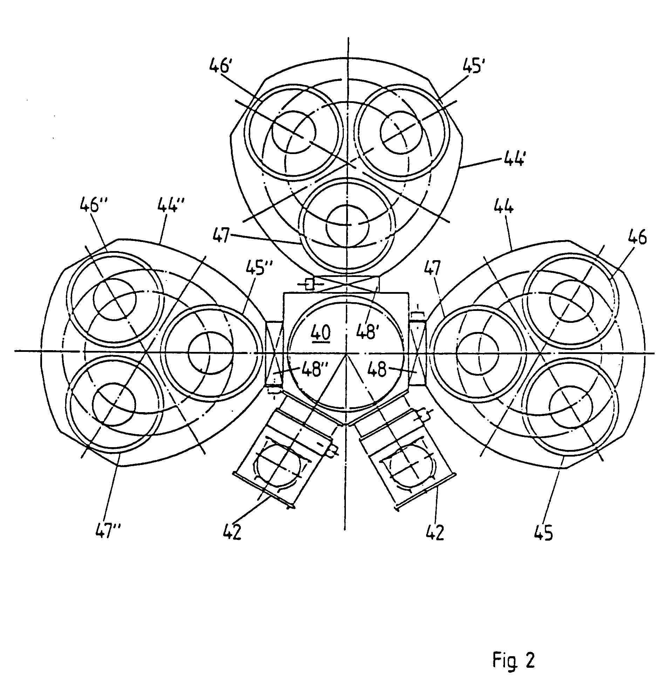

Das Schema einer solchen Anordnung zeigt die Fig. 2. Mit dem Bezugszeichen 40 ist die zentrale Verteilerkammer bezeichnet, in welche die zu behandelnden Scheiben über Schleusenkammern 42 ein- und nach der Behandlung wieder ausgebracht werden können. An diese zentrale Verteilerkammer sind an drei Seiten die Zwischenkammern 44, 44' und 44" angeschlossen und jeder dieser Zwischenkammern sind im Ausführungsbeispiel je drei Prozesskammern zugeordnet, die in der Fig. 2 schematisch mit 45, 46 und 47 bzw. 45', 46' 47' und 45", 46" und 47" bezeichnet sind. Die Verbindung zwischen der Verteilerkammer und den angeschlossenen Zwischenkammern ist durch die Ventile 48 bzw. 48' bzw. 48" gegeben, die von einer Steuereinrichtung den durchzuführenden Prozessen entsprechend geöffnet und geschlossen werden. Die oben erwähnten (in Fig. 2 nicht dargestellten) ersten und zweiten Mechanismen sind in der zentralen Verteilerkammer bzw. in den an diese angeflanschten Zwischenkammern untergebracht; sie besorgen den prozessgerechten Transport der Scheiben in die bzw. aus den einzelnen Kammern, ähnlich wie anhand des Beispiels der Fig. 1 beschrieben.

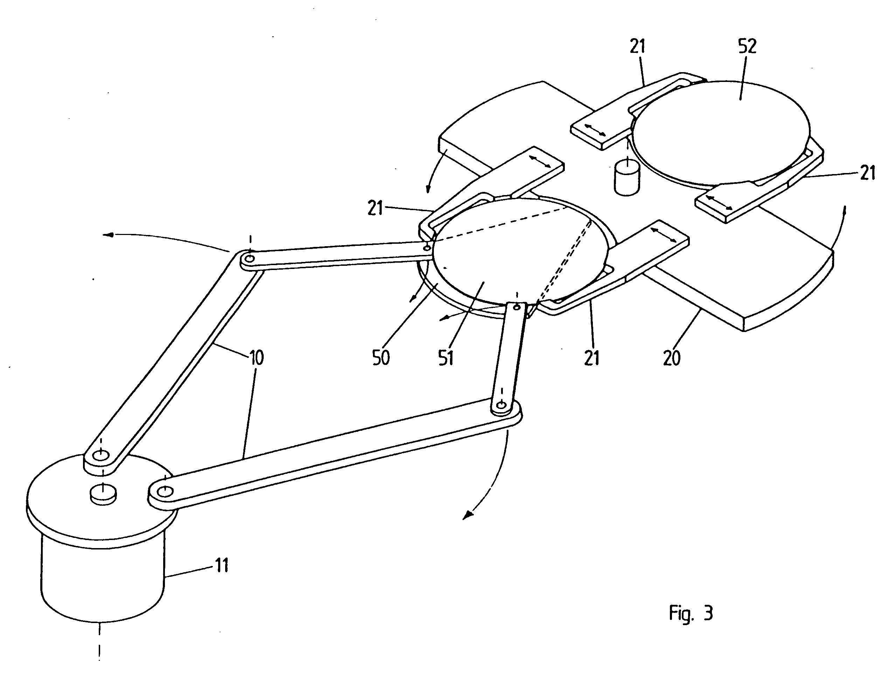

Die Fig. 3 zeigt den im Ausführungsbeispiel der Fig. 1 verwendeten ersten und zweiten Mechanismus und das Zusammenwirken der beiden. Die Bezugsziffern sind, soweit verwendet, dieselben wie in Fig. 1. An dem von der Antriebsvorrichtung 11 gesteuerten Robotarm 10 ist eine Platte so befestigt, welche unter die Scheiben greifend diese von der Kassette in der Schleusenkammer 1 übernimmt und sie sodann nach Rückziehen und Drehung des Robotarmes aus der Position 10' in die Position 10 (siehe Fig. 1) an die Greifer 21 in der Kammer 15 abgibt. Durch den zweiten Mechanismus werden die Scheiben dann durch Drehen um die Achse 20' in die richtige Position gegenüber der Oeffnung einer Prozesskammer gebracht. Die Vorrichtung gemäss Fig. 1 ist so ausgestaltet, dass die betreffende Scheibe schon nach Uebergabe an den zweiten Mechanismus sich in dieser Lage gegenüber der Prozesskammer 24 befindet. In der Darstellung der Fig. 3 wird gerade eine auf der Platte so liegende Scheibe 51 an den Greifer 21 abgegeben (und würde sich somit unterhalb der Oeffnung 22 der Fig. 1 befinden), während eine weitere Scheibe 52 in einer Stellung unterhalb der Oeffnung 23 der Prozesskammer 25 weitergedreht dargestellt ist (bei 3er-Teilung 120° Weiterdrehung).

Das erfindungsgemässe Verfahren zum Betrieb der Vakuumanlage wird anhand der Fig. 1 erläutert und ist dadurch gekennzeichnet, dass der in der Verteilerkammer 7 angeordnete erste Transport-Mechanismus 10,11,12 nacheinander jeweils ein Werkstück aus einem Magazin 4 in der Schleuse 1 entnimmt und auf dem Weg durch die Verteilerkammer 7 in eine Zwischenkammer 15 transportiert und der in der Zwischenkammer angeordnete zweite Transport-Mechanismus 20,21 das Werkstück vom ersten Transport-Mechanismus 10,11,12 übernimmt und in einer zur Verbindungsöffnung 22 oder 23 zwischen der Zwischenkammer 15 und einer Prozesskammer 24 oder 25 koaxialen Lage bereithält. Insbesondere ist dieses Betriebsverfahren bei Vorhandensein mehrerer einer Zwischenkammer 15 zugeordneten Prozesskammern 24,25 und unterhalb der Verbindungsöffnungen 22,23 zwischen letzteren und der Zwischenkammer 15 in dieser angeordneten Hubeinrichtungen 26,27 für den Auf- und Abtransport der Scheiben in und aus den Prozesskammern erfindungsgemäss dadurch gekennzeichnet, dass der zweite Transport-Mechanismus 20,21 das vom ersten Transport-Mechanismus 10,11,12 übernommene Werkstück auf eine der Hubeinrichtungen 26,27 ablegt, die das Werkstück in eine der oberhalb der Hubeinrichtungen befindliche Prozesskammer 24,25 transportiert und dass das Werkstück auf dem selben Weg bei umgekehrter Reihenfolge der Transportschritte zu der Ausgangslage zurücktransportiert wird.

Das Verfahren zum Betrieb der Vakuumanlage kann insbesondere so gestaltet werden, dass bei Vorhandensein von mindestens zwei jeweils einer Zwischenkammer 15 zugeordneten Prozesskammern 24,25 jede dieser Prozesskammern während aufeinanderfolgenden Zeitintervallen abwechselnd nach Beschickung in Funktion gesetzt und regeneriert wird, wobei während der Regenerierung einer Prozesskammer die weitere Kammer in Funktion gesetzt wird. Das bedeutet mit anderen Worten, dass bei jeder Prozesskammer auf eine bestimmte Zeitspanne, während der eine Scheibe in dieser Kammer behandelt wird, eine Zeitspanne folgt, während der diese Kammer regeneriert wird. Bei zwei vorhandenen Prozesskammern lässt sich dies abwechselnd durchführen, sodass die Regenerierungsphase und die Behandlungsphase ständig vertauscht werden.

Schliesslich lässt sich das Verfahren zum Betrieb der Vakuumanlage erfindungsgemäss auch in der Weise gestalten, dass in einer Zwischenkammer 15 anstelle einer Hubeinrichtung 26 oder 27 ein Magazin mit einem Vorrat an Scheiben angeordnet wird und dass dann eine Zwischenkammer mit mehreren beispielsweise drei dieser zugeordneten Prozesskammern als eine von der übrigen Vakuumanlage unabhängig funktionsfähige Einheit in Betrieb gesetzt wird, die mit anderen Worten autonom arbeiten kann, wenn beispielsweise die übrigen Teile der Vakuumanlage durch eine Betriebsstörung ausfallen.

Wie vorstehend bereits erwähnt worden ist, weist die Vakuumanlage in jeder vorhandenen Zwischenkammer Hubeinrichtungen auf, welche dazu dienen, eine auf der Hubeinrichtung abgelegte Scheibe in eine oberhalb der Zwischenkammer angeordnete Prozesskammer zu bringen. Bei diesem Vorgang muss das scheibenförmige Werkstück auf der Unterlage der Hubeinrichtung gesichert werden, d.h. das Werkstück ist am Rand festzuhalten, damit es eine bestimmte Lage beibehält.

Es ist bekannt, zum Festhalten des Werkstückes beispielsweise in Form einer Scheibe greiferartige Blattfedern zu verwenden, die den Scheibenrand umfassen. Diese Festhaltemittel können in eine offene und in eine geschlossene Stellung gebracht werden, in welcher sie die Scheibe festhalten. Dabei entsteht das Problem, dass diese Festhaltemittel in der Prozesskammer auch der darin für die Scheibe durchgeführten Behandlung ausgesetzt sind. Diese Behandlung ist beispielsweise eine Beschichtung mit 1µm Aluminium pro Scheibe bei einem Durchsatz von einer Scheibe pro Minute, was dann zur Folge hat, dass auf den Festhaltemitteln innerhalb von fünf Tagen eine über 7mm starke Aluminiumschicht aufwachsen wird. Es können überhängende Aluminium-Knollen entstehen, die oft zu unerwünschten Abschattungen bei der Beschichtung der Scheibe führen. Es kann auch vorkommen, dass die Scheibe mit den Festhaltemitteln zusammenwächst und dann daran kleben bleibt. Wenn es sich andererseits bei der Behandlung um einen Aetzprozess handelt, so werden die Festhaltemittel auch mitgeätzt und das von diesen abgetragene Material kann dabei die Scheibenoberfläche verunreinigen. Beim Reinigungsäzen der Scheibe durch Kathodenzerstäubung verursachen die Festhaltemittel auch Potentialverzerrungen und infolge dessen oft eine Art Hof oder Schatten.

In vielen Fällen soll die zu behandelnde Scheibe auch noch mit einer bestimmten Orientierung ihrer Lage auf der Unterlage der Hubeinrichtung positioniert sein, bevor die Scheibe in die Prozesskammer transportiert wird. Bei der Behandlung von Halbleiterscheiben für die Herstellung integrierter Mikroelektronik-Bausteine weist die Scheibe beispielsweise eine von der Kreisform abweichende Kontur auf, wobei ein Kreissegment weggeschnitten ist, was zur Kennzeichnung der Kristallorientierung dient, und die Unterlage für die Scheibe hat dieselbe von der Kreisform abweichende Kontur und die Scheibe muss bezüglich dieser Unterlage genau orientiert festgehalten und transportiert werden.

Für die Vakuumanlage der eingangs genannten Art ist daher eine Hubeinrichtung in Form eines besonderen Hubtisches mit Festhaltemitteln erforderlich, die in der Lage sind, das Werkstück in eine orientierte Lage auf der Unterlage zu bringen und das Werkstück während des Transports zu sichern, ohne dass sie selbst während der Behandlung des Werkstückes den Einwirkungen dieser Behandlung ausgesetzt sind.

Der in der Vakuumanlage zu verwendende Hubtisch soll es ferner ermöglichen, dass die Behandlung des Werkstücks in der Prozesskammer bei bestimmten und genau konstant zu haltenden Temperaturen erfolgen kann. Hierfür kann die Zuführung von Wärme gegen die Unterseite des Werkstückes oder auch eine Kühlung erforderlich sein.

Für die Lösung der erstgenannten Aufgabe der lageorientierten Anordnung des Werkstücks auf einer Unterlage und der Sicherung des Transports in die Prozesskammer dient ein Hubtisch für den Auf- und Abtransport eines scheibenförmigen Werkstückes, der eine bewegbare Werkstück-Unterlage aufweist, an der Halteorgane in und ausser Halteeingriff schwenkbewegbar angeordnet sind, um sie kurz vor Erreichen der Bearbeitungsposition der bewegten Unterlage in die Stellung ausser Halteeingriff zu bringen und in dieser Stellung während der restlichen Transportbewegung der Unterlage in die Bearbeitungsstation bis hinter eine Abdeckung zu bewegen, welche die Halteorgane vor den Einwirkungen durch die Werkstückbe-handlung schützt.

Zur Lösung der weiteren Aufgabe ist die Werkstück-Unterlage mit einer durch ein Heizelement aufheizbaren Heizplatte und mit einer Vielzahl von an der Oberfläche der Unterlage mündenden Kanälen ausgestattet, welche gemeinsam an eine Gaszuführungsleitung angeschlossen sind, um zwischen der Unterlage und dem Werkstück ein Gaspolster als homogenes Wärmeleitungsmittel zum Erhitzen des Werkstückes zu erzeugen. Das Gaspolster sorgt für eine absolut gleichmässige Wärmeverteilung unterhalb des Werkstücks. Damit das Werkstück durch das Gaspolster sich nicht von der Unterlage abhebt, dient als Gewichtsbelastung ein loser Ring, der in der Bearbeitungsstation auf dem Aussenrand des Werkstücks aufzuliegen kommt. Dieser Ring hat ausserdem noch die Aufgabe, den vorhandenen Ringspalt zwischen der das Werkstück tragenden Unterlage und der Abdeckung geschlossen zu halten. Zu diesem Zweck kann natürlich auch ein Ring verwendet werden, der nur am Rand der Unterlage aufliegt aber nicht am Rand des Werkstückes, sodass dieses auch freiliegend transportiert werden kann. Damit ist es möglich, mit derselben Einrichtung entweder ein freiliegendes oder ein am Rand gesichertes Werkstück zu bearbeiten, je nach dem welche Art der Verarbeitung gerade verlangt wird. Der Ring liegt vorzugsweise längs des ganzen Werkstückrands auf, wenn eine Dichtwirkung für das Gaspolster zwischen dem Werkstück un der Unterlage erzielt werden soll. In diesem Fall kann der Ring mittels eines Federbalgs gasdicht am Gehäuse der Vakuumanlage befestigt sein, wobei auch die Federwirkung des Federbalgs ausgenutzt werden kann, um dem Druck des Gaspolsters entgegenzuwirken. Wenn hingegen das Werkstück bis zum äussersten Rand behandelt werden soll, kann der Ring auch mit am Innenrand angeordneten Haken am Werkstückrand aufliegen, sodass ausser diesen Hakenbereichen der grösste Teil des Werkstückrands bearbeitet wird.

Der Hubtisch mit den in und ausser Halteeingriff schwenkbewegbar angeordneten Halteorganen hat den Vorteil, dass die in der Stellung ausser Halteeingriff hinter der Abdeckung geschützten Halteorgane mit dem Werkstück durch die Einwirkungen der Behandlung nicht verkleben können. Wenn jedoch das Werkstück mit dem am Rand aufliegenden Ring verklebt, erfüllen die schwenkbewegbaren Halteorgane in ihrer gegen das Werkstück einwärts geschwenkten Stellung die Funktion, bei der Rückbewegung des Hubtisches in die Ausgangslage das Werkstück durch Abreissen vom Ring zu trennen.

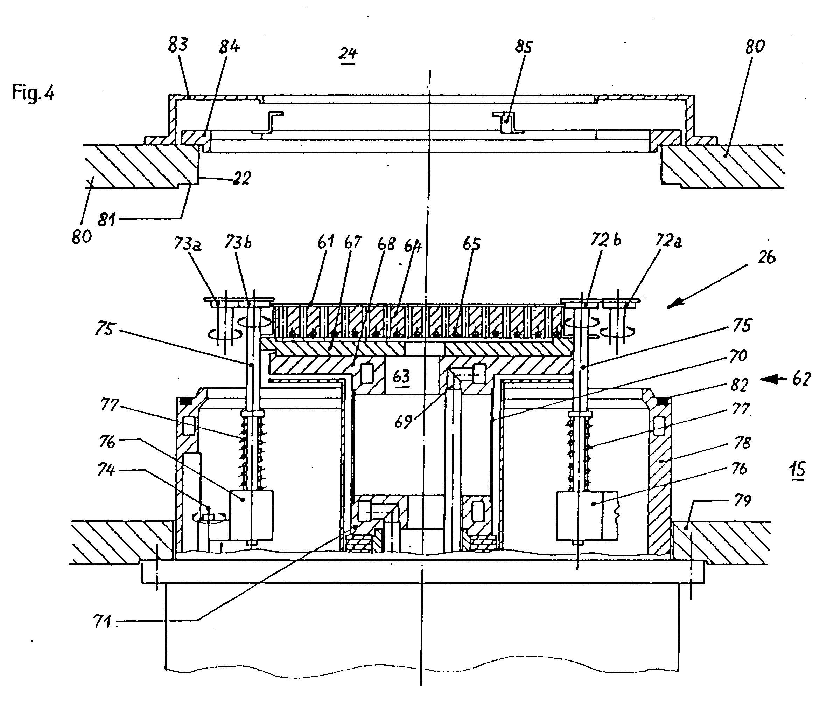

Fig. 4 zeigt die wesentlichen Teile einer der in Fig. 1 dargestellten Hubeinrichtungen 26 bzw. 27, die jeweils als Hubtisch zum Auf- und Abbewegen eines Werkstücks innerhalb der Zwischenkammer 15 ausgebildet sind. Der Hubtisch 26 ist in Fig. 4 in der sogenannten Ladeposition dargestellt, in welcher ein scheibenförmiges Werkstück 61 auf der aus mehreren Teilen bestehenden Werkstück-Unterlage 62 abgelegt ist, und zwar auf dem Zentralteil 63, der im dargestellten Beispiel mit einer Heizplatte 64 ausgestattet ist, die durch ein Heizelement 65 aufgeheizt wird und welche Heizplatte mit einer Vielzahl von vertikalen Bohrungen 66 versehen ist, durch welche hindurch ein Gas zwischen das scheibenförmige Werkstück 61 und die Oberseite der Heizplatte 64 gelangen kann. Das Heizelement 65 kann die Heizplatte 64 auf Temperaturen bis über 500°C aufheizen und das erhitzte Gas dient dann als Wärmeleitungsmittel, um das Werkstück vollkommen gleichmässig über seine Fläche zu erhitzen. Man verwendet hierfür vorzugsweise dasselbe Gas, das auch bei einem in der Vakuumanlage durchgeführten Prozess verwendet wird, weil eine gasdichte Abdichtung am Rand der Heizplatte nur sehr schwer zu erreichen ist.

Ein unterhalb der Heizplatte 64 befindlicher Flansch 67 dient zur Befestigung des Heizelements 65 und für die Gaszufuhr zu den Bohrungen 66 in der Heizplatte. Diese Heizplatte und der Flansch 67 sind zusammen auf einem weiteren Flansch 68 befestigt, der Kanäle 69 einer Schnellkühleinrichtung enthält. Der Flansch 68 ist mittels eines dünnwandigen Rohrs 70 wärmeisolierend mit einem ebenfalls gekühlten und elektrisch isoliert befestigten Teil 71 gasdicht verbunden.

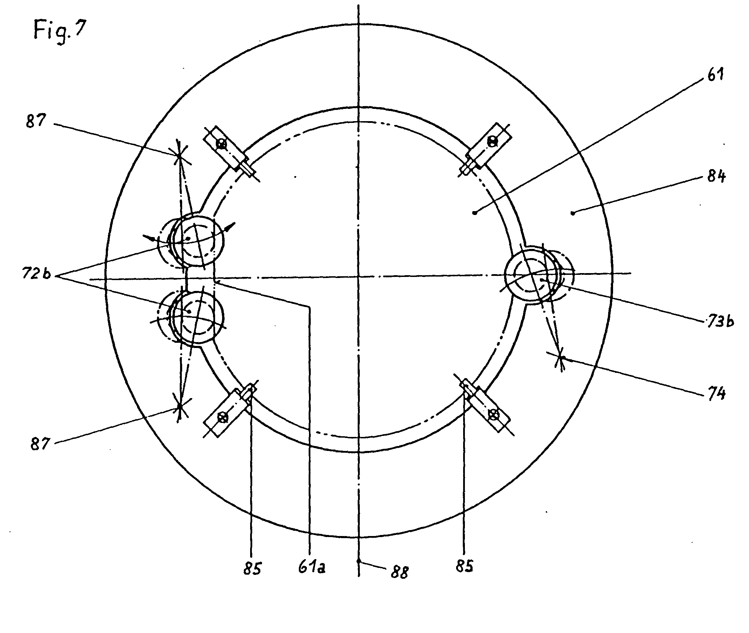

Zur auf- und abbewegbaren Werkstück-Unterlage 62 gehören ferner schwenkbewegbar an diese angeordnete Halteorgane 72 und 73. Aus Fig. 7 ist erkennbar, dass auf der einen Seite zwei dieser Halteorgane 72 vorhanden sind und auf der gegenüberliegenden Seite ein Halteorgan 73 vorhanden ist. Nach dem Ablegen des Werkstücks 61 auf der Unterlage 62 werden die Halteorgane von einer Stellung 72a bzw. 73a, in der sie sich ausser Halteeingriff am Werkstück befinden, in die Stellung 72b bzw. 73b verschwenkt, in der sie sich in Halteeingriff befinden. Zu diesem Zweck werden sie um eine zur Mittelachse der Werkstück-Unterlage 62 parallele Achse 74 verschwenkt. Bei dieser Bewegung erfolgt nötigenfalls auch eine Korrektur der Lage des Werkstücks 62 auf der Unterlage, was später noch im einzelnen anhand der Fig. 7 erläutert wird. Die Halteorgane 72 und 73 bestehen jeweils aus einem stangenförmigen Körper 75, der in einem Lager 76 um seine Achse drehbar gelagert ist. Gegen die Wirkung einer auf dem Lager abgestützten und den stangenförmigen Körper 15 umschliessenden Druckfeder 77 kann jedes Halteorgan nach unten gedrückt werden.

Zur auf- und abbewegbaren Werkstück-Unterlage 62 gehört ferner ein zylindrischer Aussenteil 78, innerhalb welchem die Halteorgane 72 und 73 schwenkbewegbar angeordnet sind. Wie auch aus Fig. 1 hervorgeht, erstreckt sich der Hubtisch 26 von unten durch eine Ausnehmung in der Kammerwand 79 der Zwischenkammer 15, wobei der Hubtisch unterseitig gegen diese Wand 79 angeflanscht ist. Oberhalb der Zwischenkammer 15 befindet sich gemäss Fig. 1 und 4 eine Prozesskammer 24, die über eine Verbindungsöffnung 22 in der dazwischen befindlichen Wand 80 miteinander in Verbindung stehen. Gegen einen an dieser Wand 80 am Rand der Oeffnung 22 als Ventilsitz 81 ausgebildeten Bereich kommt die Oberkante des zylindrischen Aussenteils 78 mit einer Dichtung 82 in Dichtungskontakt, wenn der Hubtisch 26 angehoben ist, um ein Werkstück 61 innerhalb der Prozesskammer 24 zu behandeln. Der Hubtisch 26 dient somit nicht nur für den Auf- und Abtransport der Werkstücke, sondern stellt gleichzeitig ein Ventil dar, welches die Zwischenkammer 15 von der Prozesskammer gasdicht abtrennt.

In Fig. 4 ist an der Kammerwand 80 eine innerhalb der Prozesskammer 24 befindliche ringförmige Abdekkung 83 befestigt. Unterhalb dieser Abdeckung liegt ein loser Ring 84 auf dem Rand der Kammerwand auf und ist in der Oeffnung 22 geführt. Am Innenrand besitzt dieser Ring 84 umfangsmässig verteilt angeordnete Haken 85.

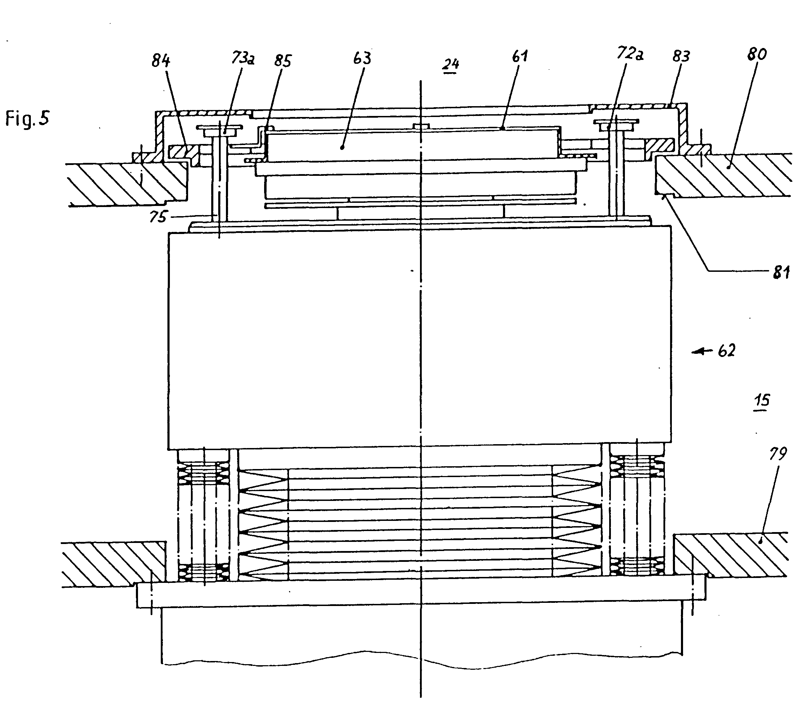

In Fig. 5 ist die Werkstück-Unterlage 62 in eine Zwischenstation hochgefahren dargestellt. Dabei hat das auf der Unterlage liegende Werkstück 61 den losen Ring 84 etwas angehoben und der Ring hängt mit seinen Haken 85 am Rand des Werkstückes, sodass dieses gegen die Heizplatte 64 angedrückt wird und gegen seitliches Verrutschen gesichert wird. Der Ring dient dabei auch als Gewichtsbelastung, um dem zuvor erwähnten Gaspolster zwischen dem Werkstück und der Heizplatte entgegenzuwirken. Ausserdem hat der Ring 84 die Aufgabe, den zwischen der Abdeckung 83 und dem auf der Unterlage hochgefahrenen Werkstück vorhandenen Ringspalt abzudecken, um die darunter befindlichen Teile von der Einwirkung durch die in der Prozesskammmer stattfindende Behandlung zu schützen. Die Halteorgane 72 und 73 sind in Fig. 5 in der Stellung ausser Halteeingriff, d.h. nach aussen geschwenkt dargestellt.

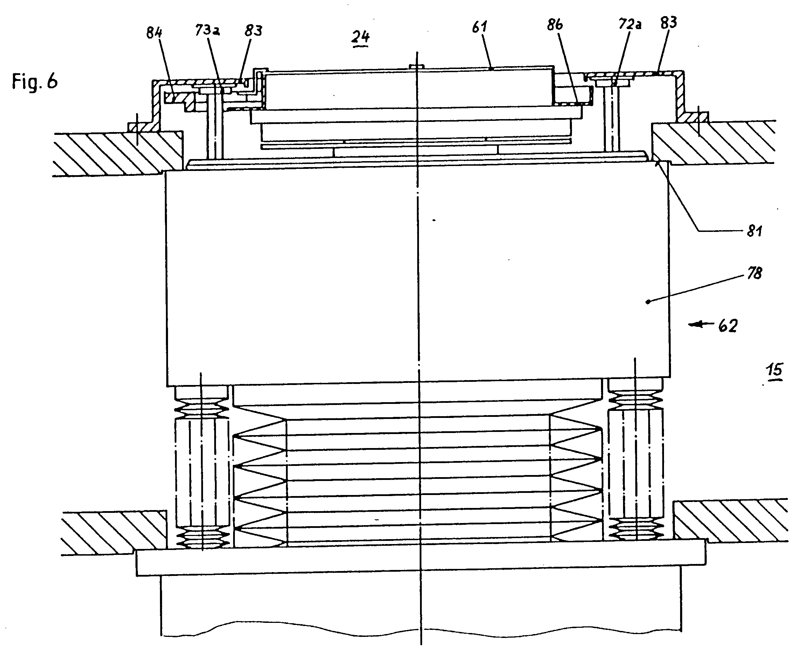

In Fig. 6 ist die Werkstück-Unterlage 62 bis in die Endstellung hochgefahren dargestellt und befindet sich in der Bearbeitungsposition. Diese Stellung ist erreicht, wenn der zylindrische Aussenteil 78 der Unterlage 62 gegen den als Ventilsitz 81 ausgebildeten Rand der Kammerwand 80 angefahren ist. Das Werkstück 61 überragt dann die Abdeckung 83 und ist der Behandlung in der Prozesskammer 24 voll ausgesetzt. Die Halteorgane 72 und 73 sind unterseitig gegen die Abdeckung 83 angedrückt, wobei sie gegen die Wirkung der Feder 77 einwärtsgeschoben werden. In dieser Stellung unterhalb der Abdeckung 83 liegen die Halteorgane 72 und 73 geschützt vor den Einwirkungen durch die Werkstückbe-handlung.

In Fig. 6 sind auf der linken und auf der rechten Hälfte verschiedene Ausführungsformen dargestellt und der bewegliche Ring 84 ist nur in der linken Hälfte erkennbar. In der rechten Hälfte dieser Figur ist eine ringförmige Abschirmung 86 dargestellt, die an der Unterlage 62 befestigt ist und die den Ringspalt zwischen der Abdeckung 83 und dem Werkstück abdeckt, um die darunterliegenden Teile vor den Einwirkungen aus der Prozesskammer zu schützen. Diese Abschirmung in Form einer Rinne muss bei Beschichtungsprozessen sich allmählich aufbauende Beläge aufnehmen, z.B. eine bis zu 7mm dicke Aluminiumschicht. Auch auf der Abdeckung 83 können solche Schichten aufwachsen, weshalb diese Abdeckung von der Prozesskammer 24 aus leicht auswechselbar ist, was ebenso auch für den losen Ring 84 und die Abschirmung 86 gilt. Die rechte Hälfte der Fig. 6 zeigt die mögliche Ausführung nur mit einer Werkstückauflageplatte, d.h. ohne Heizplatte

Fig. 7 zeigt den losen Ring 84 mit dem am Innenrand angeordneten Haken 85 in der Draufsicht von oben sowie ferner die Halteorgane 72 und 73 im Zusammenwirken mit dem strichpunktiert dargestellten scheibenförmigen Werkstück 61. Die Blickrichtung ist mit anderen Worten von der Prozesskammer 24 aus, wenn die Abdeckung 83 entfernt ist. Fig. 7 zeigt die Situation nach Erreichen der Werkstück-Unterlage 62 in der Zwischenposition gemäss Fig. 5, jedoch vor dem Auswärtsschwenken der Halteorgane 72 und 73. Die Darstellung gemäss Fig. 7 ist mit anderen Worten identisch mit der Situation in der Ladeposition gemäss Fig. 4 nach dem Einwärtsschwenken der Halteorgane, wenn man sich in Fig. 4 den losen Ring 84 in einer Ebene oberhalb des Werkstücks 61 und der Halteorgane liegend vorstellt. Die beiden vorerwähnten Situationen wiederholen sich beim Rücktransport des Werkstücks von der Bearbeitungsposition in die Ladeposition. Zweimal bei jedem Bearbeitungszyklus mit Hin- und Rücktransport, nämlich jeweils beim Einwärtsschwenken der Halteorgane 72 und 73 in die Stellung gemäss Fig. 7 wird die Werkstückorientierung korrigiert. Dabei werden zunächst die beiden Halteorgane 72 um zu der Mittelachse parallele Achsen 87, die in Fig. 4 nicht dargestellt sind, verschwenkt und hart an einen mechanischen Anschlag gedrückt. Sodann wird das Halteorgan 73 um die auch in Fig. 4 dargestellte Achse 74 einwärts geschwenkt. Das Halteorgan drückt das Werkstück 61 mit der Segmentkante 61a (oder Flat) weich gegen die beiden Halteorgane 72 und korrigiert dabei die Werkstückorientierung, wenn die Halteorgane 72 von der Segmentkante 61a nicht gleichzeitig berührt werden, d.h. wenn die Halteorgane 72 und diese Kante 61a nicht von vornherein parallel liegend waren. Eine Verschiebung des Werkstücks in Richtung der Achse 88 durch den Vorgang der Orientierungskorrektur kann in beiden Positionen begrenzt werden, nämlich in der Ladeposition durch das hier nicht beschriebene Mittel für den Werkstücktransport von einer zur anderen Station und in der Zwischenstation durch den losen Ring 84 oder daran befestigte Teile.

## Patentansprüche

1. Vakuumanlage zum Behandeln von Werkstücken mit
- einer ersten evakuierbaren Kammer (7) mit zwei Öffnungen für Werkstücke und mit einem ersten Transportmechanismus (10) für den Transport von Werkstücken zwischen den Öffnungen;
- einer zweiten evakuierbaren Kammer (15) mit mindestens drei Öffnungen für Werkstücke und mit einem zweiten Transportmechanismus (20) für den Transport von Werkstücken zwischen den Öffnungen,
wobei
eine der Öffnungen der zweiten Kammer (15) über Verschlusselemente (14) mit einer der zwei Öffnungen der ersten Kammer (7) verbunden ist und an einer der weiteren Öffnungen der zweiten Kammer (15) eine Prozesskammer für Werkstücke angebracht ist und an der dritten anbringbar ist, **dadurch gekennzeichnet, dass** die erste Kammer (7) als Verteilkammer ausgebildet ist und hierzu mindestens eine weitere Öffnung aufweist, welche ebenfalls vom ersten Transportmechanismus (10) bedient wird und mit welcher eine weitere Prozesskammer wirkverbunden ist.

2. Vakuumanlage nach Anspruch 1, **dadurch gekennzeichnet, dass** an die Verteilkammer (7) mindestens zwei zweite Kammern (15) mit zugeordneten Prozesskammern (24, 25) angeschlossen sind.

3. Vakuumanlage nach Anspruch 1 oder 2, **dadurch gekennzeichnet, dass** der zweiten Kammer (15) mehrere Prozesskammern (24, 25) zugeordnet sind.

4. Vakuumanlage nach einem der Ansprüche 1 bis 3, **dadurch gekennzeichnet, dass** der erste Transport-Mechanismus als in der Verteilkammer (7) drehbar angeordneter Robotarm (10, 11, 12) ausgebildet ist.

5. Vakuumanlage nach einem der Ansprüche 1 bis 4, **dadurch gekennzeichnet, dass** der zweite Transport-Mechanismus als um eine vertikale Achse drehbare Haltevorrichtung (20, 21) ausgebildet ist.

6. Vakuumanlage nach Anspruch 5, **dadurch gekennzeichnet, dass** die weiteren Öffnungen der zweiten Kammer (24, 25) oberhalb dieser Kammer (15) und über einer Kreisbahn der drehbaren Haltevorrichtung (20, 21) angeordnet und wahlweise abschliessbar sind.

7. Vakuumanlage nach Anspruch 6, **dadurch gekennzeichnet, dass**, unterhalb der Kreisbahn der Haltevorrichtung (20, 21), mit den weiteren Öffnungen (22, 23) fluchtende Hubeinrichtungen (26, 27) für das Hochheben bzw. Absenken der Werkstücke vorgesehen sind.

8. Vakuumanlage nach Anspruch 2, **dadurch gekennzeichnet, dass** den Verschlusselementen (13, 14) eine Steuereinrichtung zugeordnet ist, derart, dass eine gleichzeitige räumliche Verbindung zwischen zweiten Kammern (15) während eines Prozesses ausgeschlossen ist.

9. Vakuumanlage nach Anspruch 3, **dadurch gekennzeichnet, dass** den Verschlusselementen (22, 28, 23, 29) eine Steuereinrichtung zugeordnet ist, derart, dass eine gleichzeitige räumliche Verbindung zwischen den Prozesskammern (24, 25) während eines Prozesses ausgeschlossen ist.

10. Vakuumanlage nach Anspruch 7, **dadurch gekennzeichnet, dass** die Hubeinrichtungen einen Hubtisch umfassen, mit einer bewegbaren Werkstück-Unterlage und an dieser angeordneten Halteorganen (72, 73) für das Werkstück zum Sichern desselben während des Transports und dass die Halteorgane (72, 73) bezüglich des Werkstückes in und ausser Halteeingriff schwenkbewegbar an der Unterlage (62) derart angeordnet sind, dass sie kurz vor Erreichen der Werkstück-Bearbeitungsposition durch die bewegbare Unterlage (62) in die Stellung ausser Halteeingriff gebracht werden und in dieser Stellung während der restlichen Hub-Bewegung der Unterlage (62) hinter eine Abdeckung (83) bewegt werden, welche die Halteorgane (72, 73) vor den Einwirkungen durch die Behandlung schützt.

11. Vakuumanlage nach Anspruch 10, **dadurch gekennzeichnet, dass** die Unterlage (62) mit einer durch ein Heizelement (65) aufheizbaren Heizplatte (64) und mit einer Vielzahl von ihrer Oberfläche mündenden Kanälen (66) ausgestattet ist, welche gemeinsam an eine Gaszuführungsleitung angeschlossen sind, um zwischen der Unterlage (62) und dem Werkstück (61) ein Gaspolster als homogenes Wärmeleitungsmittel zum Erhitzen des Werkstückes zu erzeugen.

12. Vakuumanlage nach Anspruch 10 oder 11, **dadurch gekennzeichnet, dass** in der Unterlage (62) Kanäle (69) zum Hindurchleiten eines Mittels für eine Schnellkühlung ausgebildet sind.

13. Vakuumanlage nach Anspruch 10 und 11, **dadurch gekennzeichnet, dass** die Unterlage (62) mit ihrem oberen Teil durch eine der weiteren Öffnungen (22, 23) in die Behandlungskammer (24, 25) hineinbewegbar ist und in ihrer Bearbeitungsposition ihre Oberfläche die kammerwandseitig fest angeordnete ringförmige Abdeckung (83) überragt, dass weiter unterhalb der Abdeckung ein auf dem Öffnungsrand abgestützter loser Ring (84) angeordnet ist, der geeignet ist, beim Hochfahren der Unterlage (62) sich am Werkstückrand (61) abzustützen und als Gewichtsbelastung das Werkstück gegen die Unterlage (62) bzw. ein auf dieser vorhandenes Gaspolster angedrückt zu halten sowie den Ringspalt zwischen der Unterlage (62) und der Abdeckung (83) geschlossen zu halten.

14. Vakuumanlage nach Anspruch 13, **dadurch gekennzeichnet, dass** die Unterlage (62) stufenkolbenartig abgesetzt ausgebildet ist und ein im Durchmesser grösserer Abschnitt (78) am Aussenrand als Ventilteller (82) ausgebildet ist zwecks Anlage gegen den Rand der weiteren Öffnung zur gasdichten Abtrennung der zweiten Kammer und der Behandlungskammer.

15. Vakuumanlage nach Anspruch 14, **dadurch gekennzeichnet, dass** die Halteorgane (72, 73) in dem im Durchmesser grösseren Abschnitt (78) der Unterlage (62) schwenkbeweglich gelagert sind und zur Hubrichtung parallele Stangen (75) umfassen sowie am Ende eine Scheibe zum Übergreifen des Werkstückrands, und dass die Stangen (75) in ihrer Achsrichtung federnd gehalten sind, um in der Stellung ausser Halteeingriff am Werkstück gegen die Abdeckung (83) federnd angedrückt zu werden.

16. Vakuumanlage nach einem der Ansprüche 10 bis 15, **dadurch gekennzeichnet, dass** zwei schwenkbare Halteorgane (72) auf einer Seite und ein Halteorgan (73) auf der gegenüberliegenden Seite der Unterlage (62) angeordnet sind, um durch Verschwenken im Zusammenwirken ein Werkstück (81) lageorientiert auf der Unterlage (62) zu positionieren.

17. Vakuumanlage nach Anspruch 7, **dadurch gekennzeichnet, dass** die Hubeinrichtungen eine als Abstützung für ein Werkstück (61) dienende Auflageplatte (64) mit einer Vielzahl über die Plattenoberfläche, vorzugsweise regelmässig angeordneter, die Platte durchsetzende Bohrungen (16) aufweist, an welche Auflageplatte (64) eine Gasverteilkammer angrenzt, in die die Bohrungen münden, und welche mit einer Gaszufuhr in Verbindung steht, derart, dass ein als Wärmetransportmedium zwischen der Auflageplatte (64) und dem Werkstück (61) wirkendes Gas grossflächig zwischen diesen eindüsbar ist.

18. Vakuumanlage nach Anspruch 17, **dadurch gekennzeichnet, dass** die Auflageplatte (64) derart ausgebildet ist, dass das Gas peripher abströmt.

19. Vakuumanlage nach einem der Ansprüche 1 bis 18, **dadurch gekennzeichnet, dass** ein Transportmechanismus eine zu einer Transportebene senkrecht angeordnete Drehachse (20') und mindestens einen radial zur Drehachse und parallel zur Ebene sich erstreckenden Auslegearm (20) umfasst, an dem zwecks Erfassen und Freigeben eines Werkstückes zwei Haltearme (21) längs des Auslegearms beweglich angeordnet sind.

20. Vakuumanlage nach Anspruch 19, **dadurch gekennzeichnet, dass** die Haltearme (21) in bezug auf eine die Drehachse umfassende Ebene (20') gleichzeitig auf diese bzw. von dieser weg bewegbar sind, um ein Werkstück zu ergreifen oder freizugeben.

21. Vakuumanlage nach Anspruch 20, **dadurch gekennzeichnet, dass** die Drehachse (20') mit einem Antrieb verbunden ist, der die Auslegearme (20) mit den Haltearmen (21) in einer Kreisebene um festlegbare Schwenkwinkel verschwenkt.

22. Vakuumanlage nach einem der Ansprüche 1 bis 21, **dadurch gekennzeichnet, dass** die erste Kammer (7) über einen Pumpanschluss mit einer Pumpanordnung (32) wirkverbunden ist.

23. Anlage nach einem der Ansprüche 1 bis 22, **dadurch gekennzeichnet, dass** die zweite Kammer (15) mittels eines Pumpanschlusses mit einer Pumpanordnung (32) wirkverbunden ist.

24. Anlage nach einem der Ansprüche 1 bis 23, **dadurch gekennzeichnet, dass** die an der zweiten Kammer (15) vorgesehene Prozesskammer mittels eines Pumpanschlusses mit einer Pumpanordnung wirkverbunden ist.

25. Anlage nach einem der Ansprüche 1 bis 24, **dadurch gekennzeichnet, dass** die erste Kammer (7) über ein Verschlusselement (48) mit der weiteren Prozesskammer (45, 46, 47) wirkverbunden ist.

26. Anlage nach einem der Ansprüche 1 bis 25, **dadurch gekennzeichnet, dass** die zweite Kammer (15) über ein Verschlusselement mit der an ihrer weiteren Öffnung vorgesehenen Prozesskammer verbunden ist.

27. Verfahren zum Betrieb der Vakuumanlage nach einem der Ansprüche 1 bis 26, **dadurch gekennzeichnet, dass** der in der ersten Kammer (7) angeordnete erste Transportmechanismus (10, 11, 12) nacheinander jeweils ein Werkstück von einer Schleuse (1) nimmt und in die zweite Kammer (15) oder gegen die weitere Prozesskammer transportiert, und der in der zweiten Kammer (15) angeordnete zweite Transportmechanismus (20, 21) ein in die zweite Kammer (15) transportiertes Werkstück vom ersten Transportmechanismus übernimmt und in eine auf die weitere Öffnung der zweiten Kammer (15) ausgerichtete Lage transportiert.

28. Verfahren nach Anspruch 27, bei Vorhandensein mehrerer einer zweiten Kammer (15) zugeordneter Prozesskammern (24, 25) und unterhalb ihrer weiteren Öffnungen (22, 23) von Hubeinrichtungen (26, 27) für den Auf- und Abtransport der Werkstücke, **dadurch gekennzeichnet, dass** das vom ersten Transport-Mechanismus (10, 11, 12) übernommene Werkstück auf eine der Hubeinrichtungen abgelegt wird und damit das Werkstück in die oberhalb der Hubeinrichtung befindliche Prozesskammer (24, 25) transportiert wird, und dass das Werkstück auf demselben Weg bei umgekehrter Reihenfolge der Transportschritte zu einer Schleuse an der Verteilkammer (7) zurücktransportiert wird.

29. Verfahren nach Anspruch 27 oder 28, **dadurch gekennzeichnet, dass** bei Vorhandensein von mindestens zwei einer zweiten Kammer (15) zugeordneter Prozesskammern (24, 25) jede dieser Prozesskammern während aufeinanderfolgenden Zeitintervallen abwechselnd in Funktion gesetzt bzw. regeneriert wird, wobei während der Regenerierung einer Prozesskammer eine weitere Prozesskammer in Funktion gesetzt wird.

30. Verfahren nach einem der Ansprüche 27 bis 29, **dadurch gekennzeichnet, dass** eine zweite Kammer (15) mit mindestens einer Prozesskammer (24, 25) und mit einem in der zweiten Kammer angeordneten Magazin als von der übrigen Vakuumanlage unabhängig funktionsfähige Einheit in Betrieb gesetzt wird, beispielsweise bei Betriebsstörung in den übrigen Teilen der Vakuumanlage.

31. Verfahren zur Behandlung von Werkstücken mittels einer Vakuumanlage nach einem der Ansprüche 1 bis 26, **dadurch gekennzeichnet, dass** man Bearbeitungsprozesse an jeweils einer zweiten Kammer (15) gruppiert und gemeinsam über das Verschlusselement von der ersten Kammer abschotet.

## Claims

1. Vacuum plant for processing workpieces with
- a first evacuable chamber (7) with two openings for workpieces and with a first transport mechanism (10) for transporting workpieces between the openings;
- a second evacuable chamber (15) with at least three openings for workpieces and with a second transport mechanism (20) for transport of workpieces between the openings,
where one of the openings of the second chamber (15) is connected via sealing elements (14) with one of the two openings of the first chamber (7) and a process chamber for workpieces is arranged at one of the further openings of the second chamber (15) and can be arranged at the third, **characterised in that** the first chamber (7) is formed as a distribution chamber and for this has at least one further opening which is also served by the first transport mechanism (10) and with which a further process chamber is actively connected.

2. Vacuum plant according to claim 1, **characterised in that** connected to the distribution chamber (7) are at least two second chambers (15) with allocated process chambers (24, 25).

3. Vacuum plant according to claim 1 or 2, **characterised in that** several process chambers (24, 25) are allocated to the second chamber (15).

4. Vacuum plant according to any of claims 1 to 3, **characterised in that** the first transport mechanism is formed as a robot arm (10, 11, 12) arranged rotatably in the distribution chamber (7).

5. Vacuum plant according to any of claims 1 to 4, **characterised in that** the second transport mechanism is formed as a holder device (20, 21) rotatable about a vertical axis.

6. Vacuum plant according to claim 5, **characterised in that** the further openings of the second chamber (24, 25) are arranged above this chamber (15) and over an orbit of the rotatable holder device (20, 21) and can be closed as required.

7. Vacuum plant according to claim 6, **characterised in that** below the orbit of the holder device (20, 21) and aligned with the further openings (22, 23) are provided lift devices (26, 27) for raising and lowering the workpieces.

8. Vacuum plant according to claim 2, **characterised in that** a control device is allocated to the sealing elements (13, 14) such that a simultaneous physical connection between two chambers (15) during a process is excluded.

9. Vacuum plant according to claim 3, **characterised in that** a control device is allocated to the sealing elements (22, 28, 23, 29) such that a simultaneous physical connection between the process chambers (24, 25) during a process is excluded.

10. Vacuum plant according to claim 7, **characterised in that** the lift devices comprise a lifting table with a mobile workpiece support and arranged on this holder elements (72, 73) for the workpiece to secure this during transport, and that the holder elements (72, 73) are arranged on the support (62) swivelling in and out of a holding engagement with regard to the workpiece such that shortly before reaching the workpiece processing position they are brought by the mobile support (62) into the position out of holding engagement and in this position during the remaining lift movement of the support (62) are moved behind a cover (83) which protects the holding elements (72, 73) from the effects of processing.

11. Vacuum plant according to claim 10, **characterised in that** the support (62) is fitted with a heating plate (64) heatable by a heating element (65) and with a multiplicity of channels (66) opening on its surface which are together connected to a gas supply line in order to generate between the support (62) and the workpiece (61) a gas cushion as a homogeneous heat conduction means to heat the workpiece.

12. Vacuum plant according to claim 10 or 11, **characterised in that** channels (69) are formed in the support (62) for transfer of a means for fast cooling.

13. Vacuum plant according to claim 10 and 11, **characterised in that** the support (62) can be moved with its upper part through one of the further openings (22, 23) into the processing chamber (24, 25) and in its operating position its surface projects over the annular cover (83) firmly arranged on the chamber wall side, that further below the cover is arranged a loose ring (84) supported on the opening edge and able, on raising of the support (62), to support itself on the workpiece edge (61) and as a weight loading hold the workpiece pressed against the support (62) or a gas cushion present thereon and hold the ring gap between the support (62) and the cover (83) closed.

14. Vacuum plant according to claim 13, **characterised in that** the support (62) is formed stepped in a differential piston-like manner and a section (78) of larger diameter is formed on the outer edge as a valve plate (82) for the purpose of resting against the edge of the further opening for gas-tight separation of the second chamber and the processing chamber.

15. Vacuum plant according to claim 14, **characterised in that** the holding elements (72, 73) are mounted swivelling in the larger diameter section (78) of the support (62) and contain rods (75) parallel to the lift direction and at the end a plate to overlap the workpiece edge, and that the rods (75) are held spring-mounted in their axial direction in order, in the position out of holding engagement on the workpiece, to be pressed elastically against the cover (83).

16. Vacuum plant according to any of claims 10 to 15, **characterised in that** two swivellable holding elements (72) are arranged on one side and one holding element (73) on the opposite side of the support (62) in order by swivelling in co-operation to position a workpiece (81) location-oriented on the support (62).

17. Vacuum plant according to claim 7, **characterised in that** the lift devices have a support plate (64) serving as support for a workpiece (61) with a multiplicity of bores (16) penetrating the plate and arranged preferably regularly over the plate surface, at which support plate (64) abuts a gas distribution chamber in which the bores open and which is connected with a gas supply such that a gas acting as a heat transport medium between the support plate (64) and the workpiece (61) can be injected over a broad area between these.

18. Vacuum plant according to claim 17, **characterised in that** the support plate (64) is structured such that the gas flows away peripherally.

19. Vacuum plant according to any of claims 1 to 18, **characterised in that** a transport mechanism comprises a hinge pin (20') arranged vertical to a transport plane and extending radial to the hinge pin and parallel to the plane at least one extension arm (20), on which for the purpose of grasping and releasing a workpiece two holder arms (21) are arranged mobile along the extension arm.

20. Vacuum plant according to claim 19, **characterised in that** the holder arms (21) in relation to a plane (20) containing the hinge pin can be moved simultaneously to this or away from this in order to grasp or release a workpiece.

21. Vacuum plant according to claim 20, **characterised in that** the hinge pin (20') is connected with a drive which swivels the extension arms (20) with the holder arms (21) in a circular plane about a specifiable swivel angle.

22. Vacuum plant according to any of claims 1 to 21, **characterised in that** the first chamber (7) is actively connected via a pump connection with a pump arrangement (32).

23. Plant according to any of claims 1 to 22, **characterised in that** the second chamber (15) is actively connected by means of a pump connection to a pump arrangement (32).

24. Plant according to any of claims 1 to 23, **characterised in that** the process chamber provided on the second chamber (15) is actively connected by means of a pump connection with a pump arrangement.

25. Plant according to any of claims 1 to 24, **characterised in that** the first chamber (7) is actively connected via a sealing element (48) with the further process chamber (45, 46, 47).

26. Plant according to any of claims 1 to 25, **characterised in that** the second chamber (15) is connected via a sealing element with the process chamber provided at its further opening.

27. Process for operation of the vacuum plant according to any of claims 1 to 26, **characterised in that** the first transport mechanism (10, 11, 12) arranged in the first chamber (7) each time in succession takes a workpiece from a lock (1) and transports this to the second chamber (15) or towards the further process chamber, and that the second transport mechanism (20, 21) arranged in the second chamber (15) takes a workpiece transported in the second chamber (15) from the first transport mechanism and transports this into a position aligned on the further opening of the second chamber (15).

28. Process according to claim 27, in the presence of several process chambers (24, 25) allocated to a second chamber (15) and below their further openings (22, 23) of lift devices (26, 27) for the transport and extraction of workpieces, **characterised in that** the workpiece taken by the first transport mechanism (10, 11, 12) is deposited on one of the lift devices and thus the workpiece transported to the process chamber (24, 25) above the lift device, and that in the same way in reverse the workpiece is transported back to a lock on a distribution chamber (7).

29. Process according to claim 27 or 28, **characterised in that** in the presence of at least two process chambers (24, 25) allocated to a second chamber (15), each of these process chambers is set in function or regenerated alternately in successive time intervals, where during regeneration of a process chamber a further process chamber is set in function.

30. Process according to any of claims 27 to 29, **characterised in that** a second chamber (15) with at least one process chamber (24, 25) and with a magazine arranged in the second chamber is set in operation as a functioning unit independently of the remaining vacuum plant, for example on operation interruption in the other parts of the vacuum plant.

31. Process for treating workpieces by means of a vacuum plant according to any of claims 1 to 26, **characterised in that** treatment processes are grouped at a second chamber (15) in each case and jointly separated from the first chamber by the sealing element.

## Revendications

1. Installation à vide pour traiter des pièces, comprenant :
- une première chambre (7) dans laquelle on peut faire le vide et qui comporte deux ouvertures pour les pièces et un premier mécanisme de transport (10) pour le transport des pièces entre les ouvertures ;
- une seconde chambre (15) dans laquelle on peut faire le vide et qui comporte au moins trois ouvertures pour les pièces et un second mécanisme de transport (20) pour le transport des pièces entre les ouvertures,
étant précisé que l'une des ouvertures de la seconde chambre (15) est reliée par l'intermédiaire d'éléments de fermeture (14) à l'une des deux ouvertures de la première chambre (7) et qu'une chambre de traitement pour les pièces est installée au niveau de l'une des autres ouvertures de la seconde chambre (15) et peut être installée au niveau de la troisième,
**caractérisée en ce que** la première chambre (7) est conçue comme une chambre de distribution et présente à cet effet au moins une autre ouverture qui est desservie elle aussi par le premier mécanisme de transport (10) et à laquelle une autre chambre de traitement est reliée suivant une relation fonctionnelle.

2. Installation à vide selon la revendication 1, **caractérisée en ce qu'**au moins deux secondes chambres (15) avec des chambres de traitement associées (24, 25) sont reliées à la chambre de distribution (7).

3. Installation à vide selon la revendication 1 ou 2, **caractérisée en ce que** plusieurs chambres de traitement (24, 25) sont associées à la seconde chambre (15).

4. Installation à vide selon l'une des revendications 1 à 3, **caractérisée en ce que** le premier mécanisme de transport est conçu comme un bras de robot (10, 11, 12) disposé en rotation dans la chambre de distribution (7).

5. Installation à vide selon l'une des revendications 1 à 4, **caractérisée en ce que** le second mécanisme de transport est conçu comme un dispositif porteur (20, 21) apte à tourner autour d'un axe vertical.

6. Installation à vide selon la revendication 5, **caractérisée en ce que** les autres ouvertures de la seconde chambre (24, 25) sont disposées au-dessus de cette chambre (15) et sur une trajectoire circulaire du dispositif porteur rotatif (20, 21), et sont aptes à être fermées sélectivement.

7. Installation à vide selon la revendication 6, **caractérisée en ce qu'**il est prévu, sous la trajectoire circulaire du dispositif porteur (20, 21), des dispositifs élévateurs (26, 27) qui sont situés dans l'alignement des autres ouvertures (22, 23) et qui sont destinées à soulever et abaisser les pièces.

8. Installation à vide selon la revendication 2, **caractérisée en ce qu'**un dispositif de commande est associé aux éléments de fermeture (13, 14) de manière à empêcher une liaison dans l'espace simultanée entre des secondes chambres (15) pendant un traitement.

9. Installation à vide selon la revendication 3, **caractérisée en ce qu'**un dispositif de commande est associé aux éléments de fermeture (22, 28, 23, 29) de manière à empêcher une liaison dans l'espace simultanée entre les chambres de traitement (24, 25) pendant un traitement.

10. Installation à vide selon la revendication 7, **caractérisée en ce que** les dispositifs élévateurs comprennent une table élévatrice pourvue d'un porte-pièce mobile et d'organes d'arrêt (72, 73) prévus sur celui-ci pour bloquer la pièce pendant le transport, et **en ce que** les organes d'arrêt (72, 73) sont disposés sur le support (62) pour pouvoir pivoter et bloquer ou débloquer la pièce, de telle sorte que juste avant que le support mobile (62) n'atteigne la position de traitement de pièce, ils pivotent jusqu'à leur position de déblocage et, pendant le reste du mouvement du support (62), sont amenés dans cette position derrière un recouvrement (83) qui les protège (72, 73) des influences provenant du traitement.

11. Installation selon la revendication 10,
**caractérisée en ce que** le support (62) est équipé d'une plaque chauffante (64) apte à être chauffée par un élément chauffant (65), et de plusieurs conduits (66) qui débouchent à la surface de ladite plaque chauffante (64) et qui sont reliés conjointement à une conduite d'amenée de gaz afin de générer entre le support (62) et la pièce (61) une couche de gaz comme moyen de conduction de chaleur homogène pour chauffer la pièce.

12. Installation selon la revendication 10 ou 11, **caractérisée en ce qu'**il est prévu dans le support (62) des conduits (69) pour faire passer un agent pour un refroidissement rapide.

13. Installation à vide selon les revendications 10 et 11, **caractérisée en ce que** le support (62) est apte à être amené avec sa partie supérieure dans la chambre de traitement (24, 25), par l'une des autres ouvertures (22, 23), **en ce que** dans sa position de traitement, sa surface dépasse du recouvrement annulaire fixe (83) disposé du côté de la paroi de la chambre, et **en ce qu'**il est également prévu, au-dessous du recouvrement, une bague lâche (84) qui est en appui sur le bord de l'ouverture et qui est apte à s'appuyer contre le bord de la pièce (61), lors du soulèvement du support (62), et, comme contrepoids, à maintenir la pièce pressée contre le support (62) ou contre une couche de gaz présente sur celui-ci, et enfin à maintenir fermé l'interstice annulaire entre le support (62) et le recouvrement (83).

14. Installation à vide selon la revendication 13, **caractérisée en ce que** le support (62) a une forme étagée comme un piston à gradins, et **en ce qu'**une section à *plus* grand diamètre (78) est conçue, sur son bord extérieur, comme une tête de soupape (82) en vue de s'appliquer contre le bord de l'autre ouverture et d'assurer une séparation étanche au gaz entre la seconde chambre et la chambre de traitement.

15. Installation à vide selon la revendication 14, **caractérisée en ce que** les organes d'arrêt (72, 73) sont montés pivotants dans la section à grand diamètre (78) du support (62) et comprennent des tiges (75) parallèles au sens de soulèvement et, à leur extrémité, un plateau pour recouvrir partiellement le bord de la pièce, et **en ce que** les tiges (75) sont montées sur ressort dans leur sens axial afin d'être pressées par ressort contre le recouvrement (83), dans la position débloquée de la pièce.

16. Installation à vide selon l'une des revendications 10 à 15, **caractérisée en ce que** deux organes d'arrêt pivotants (72) sont prévus sur un côté tandis qu'un organe d'arrêt (73) est prévu sur le côté opposé du support (62) afin de positionner une pièce (81) suivant la bonne orientation sur le support (62) en pivotant conjointement.

17. Installation à vide selon la revendication 7, **caractérisée en ce que** les dispositifs élévateurs comportent une plaque d'appui (64) qui sert d'appui pour une pièce (61), qui présente plusieurs perçages (16) disposés de préférence de manière régulière sur sa surface et traversant ladite plaque, et près de laquelle se trouve une chambre de répartition de gaz dans laquelle les perçages débouchent et qui est reliée à une amenée de gaz, de telle sorte qu'un gaz agissant comme agent caloporteur entre ladite plaque d'appui (64) et la pièce (61) puisse être injecté entre celles-ci sur une grande surface.

18. Installation à vide selon la revendication 17, **caractérisée en ce que** la plaque d'appui (64) est conçue de telle sorte que le gaz s'écoule sur sa périphérie.

19. Installation à vide selon l'une des revendications 1 à 18, **caractérisée en ce qu'**un mécanisme de transport comprend un axe de rotation (20') perpendiculaire à un plan de transport, et au moins un bras en porte-à-faux (20) qui s'étend radialement par rapport à l'axe de rotation et parallèlement au plan, et sur lequel deux bras porteurs (21) mobiles le long du bras sont disposés pour prendre et libérer une pièce.

20. Installation à vide selon la revendication 19, **caractérisée en ce que** les bras porteurs (21) sont aptes à être rapprochés ou éloignés simultanément d'un plan (20') couvrant l'axe de rotation, afin de prendre ou de libérer une pièce.

21. Installation à vide selon la revendication 20, **caractérisée en ce que** l'axe de rotation (20') est relié à un entraînement qui fait pivoter les bras en porte-à-faux (20) avec les bras porteurs (21) dans un plan circulaire, suivant des angles de pivotement aptes à être fixés.

22. Installation à vide selon l'une des revendications 1 à 21, **caractérisée en ce que** la première chambre (7) est en relation fonctionnelle, par l'intermédiaire d'un raccordement de pompe, à un dispositif de pompage (32).

23. Installation selon l'une des revendications 1 à 22, **caractérisée en ce que** la seconde chambre (15) est en relation fonctionelle, grâce à un raccordement de pompe, à un dispositif de pompage (32).

24. Installation selon l'une des revendications 1 à 23, **caractérisée en ce que** la chambre de traitement prévue au niveau de la seconde chambre (15) est en relation fonctionnelle, grâce à un raccordement de pompe, à un dispositif de pompage.

25. Installation selon l'une des revendications 1 à 24, **caractérisée en ce que** la première chambre (7) est en relation fonctionnelle, par l'intermédiaire d'un élément de fermeture (48), avec l'autre chambre de traitement (45, 46, 47).

26. Installation selon l'une des revendications 1 à 25, **caractérisée en ce que** la seconde chambre (15) est reliée par l'intermédiaire d'un élément de fermeture à la chambre de traitement prévue au niveau de son autre ouverture.

27. Procédé pour faire fonctionner l'installation à vide selon l'une des revendications 1 à 26, **caractérisé en ce que** le premier mécanisme de transport (10, 11, 12) disposé dans la première chambre (7) prend les pièces dans un sas (1) les unes après les autres et les transporte jusque dans la seconde chambre (15) ou vers l'autre chambre de traitement, tandis que le second mécanisme de transport (20, 21) disposé dans la seconde chambre (15) prend sur le premier mécanisme de transport une pièce amenée dans la seconde chambre (15) et l'amène dans une position orientée vers l'autre ouverture de la seconde chambre (15).

28. Procédé selon la revendication 27, dans le cas de plusieurs chambres de traitement (24, 25) associées à une seconde chambre (15) et de dispositifs élévateurs (26, 27) disposés sous leurs autres ouvertures (22, 23) et destinés à soulever et abaisser les pièces, **caractérisé en ce que** la pièce prise par le premier mécanisme de transport (10, 11, 12) est déposée sur l'un des dispositifs élévateurs et est ainsi amenée dans la chambre de traitement (24, 25) située au-dessus du dispositif élévateur, et **en ce que** la pièce est ramenée par le même chemin, dans l'ordre inverse, à un sas prévu au niveau de la chambre de distribution (7).

29. Procédé selon la revendication 27 ou 28,
**caractérisé en ce que** s'il y a au moins deux chambres de traitement (24, 25) associées à une seconde chambre (15), chacune de ces chambres de traitement est alternativement mise en marche et régénérée, pendant des laps de temps qui se suivent, moyennant quoi pendant la régénération d'une chambre de traitement, une autre chambre de traitement est mise en marche.

30. Procédé selon l'une des revendications 27 à 29, **caractérisé en ce qu'**une seconde chambre (15) pourvue d'au moins une chambre de traitement (24, 25) et contenant un magasin est utilisée comme unité apte à fonctionner indépendamment du reste de l'installation à vide, par exemple en cas de défaillance dans les autres éléments de l'installation à vide.

31. Procédé pour traiter des pièces à l'aide d'une installation à vide selon l'une des revendications 1 à 26, **caractérisé en ce qu'**on groupe des traitements au niveau d'une seconde chambre (15) et on les isole conjointement par rapport à la première chambre par l'intermédiaire de l'élément de fermeture.
